# EUROPEAN PATENT APPLICATION

(11) **EP 0 545 411 A2**
(43) Date of publication of application: **09.06.1993**
(21) Application number: 92120649.6
(22) Date of filing: 03.12.1992
(51) Int. Cl.: H01L 21/90, H01L 21/3105

(54) **Method for improving the step coverage at contact windows**

(30) Priority: 06.12.1991 DE 4140330
(71) Applicant: TEXAS INSTRUMENTS DEUTSCHLAND GMBH, D-85356 Freising (DE)
(72) Inventor: Endl, Helmut I., W-8050 Freising (DE); Rinck, Helmut, W-8052 Moosburg (DE)
(74) Representative: Schwepfinger, Karl-Heinz, Dipl.-Ing.

(57) **Abstract**

On the first metallization layer (14, 16) a silicon dioxide layer (18) is formed on which a second silicon dioxide layer (20) is formed by means of a spin operation. The further silicon dioxide layer (20) is subjected to a plasma oxidation for hardening. On the further silicon dioxide layer (20) a photoresist mask (26) is formed which at predetermined areas leaves free windows (28) at which a contact connection to the lower metallization layer (14, 16) is to be established. In the exposed areas of the photoresist mask (26) the two silicon dioxide layers (18, 20) are removed by means of an etching solution until the lower metallization layer (14, 16) is exposed. The further silicon dioxide layer (20) is then completely removed by sputter etching.

## Description

The invention relates to a method for improving the step coverage at contact windows for establishing contact connections between a lower first metallization layer and an upper second metallization layer in the fabrication of integrated semiconductor circuits.

In the fabrication of integrated semiconductor circuits in the course of the individual fabrication steps on the surface of the semiconductor body layers of different materials are formed, at the edges of which respective steps descending with varying degrees of steepness are present. In particular with highly integrated circuits in which metallizations are present in several planes, to establish connections between the individual metallization planes contact windows must be formed and the edges thereof form steep steps. At the transition from an upper metallization layer to the lower metallization layer, in the region of the contact windows the problem of step coverage is encountered. This means the difficulty of avoiding as far as possible a reduction in the cross-sectional area of the current-carrying path from the upper metallization layer to the lower metallization layer also in the region of the steps of the contact windows because an excessive reduction of this cross-section can possibly lead to a destruction of the desired connection between the two metallization layers.

The problem underlying the invention is to provide a method of the type set forth above in which the problem of the cross-sectional reduction of the connection between metallisation layers at the steps of the contact windows no longer occurs.

According to one aspect of the present invention there is provided a method of improving the step coverage at contact windows for establishing contact connections between a lower first metallization layer and an upper second metallization layer in the fabrication of integrated semiconductor circuits, characterised by the following steps: forming a silicon dioxide layer on one of the metallization layer; applying a further layer of silicon dioxide on the silicon dioxide layer; hardening the further silicon dioxide layer; forming a photoresist mask on the further silicon dioxide layer which at predetermined areas leaves windows at which a contact connection to the metallization layer is to be established; removing the silicon dioxide layers in the exposed areas of the photoresist mask, until the lower metallization layer is exposed; and removing the remainder of the further silicon dioxide layer.

When using the method according to the invention steep steps are no longer formed at the edges of the contact windows; on the contrary, there is a gradual rise from the plane of the first metallisation layer to the plane in which the second metallization layer is to be formed so that the problem of the step coverage, i.e. the undesired cross-sectional reduction in the region of the contact window edges, no longer occurs.

The invention will now be explained by way of example with the aid of the drawings, wherein:
- Fig. 1: shows a section of an integrated circuit in the region of a contact window in the method stage after application of a photoresist mask,
- Fig. 2: shows the section of Fig. 1 after exposure of the lower metallization layer,
- Fig. 3: shows the section of Fig. 1 after removal of the photoresist mask and
- Fig. 4: shows the section of Fig. 3 after removal of the further silicon dioxide layer.

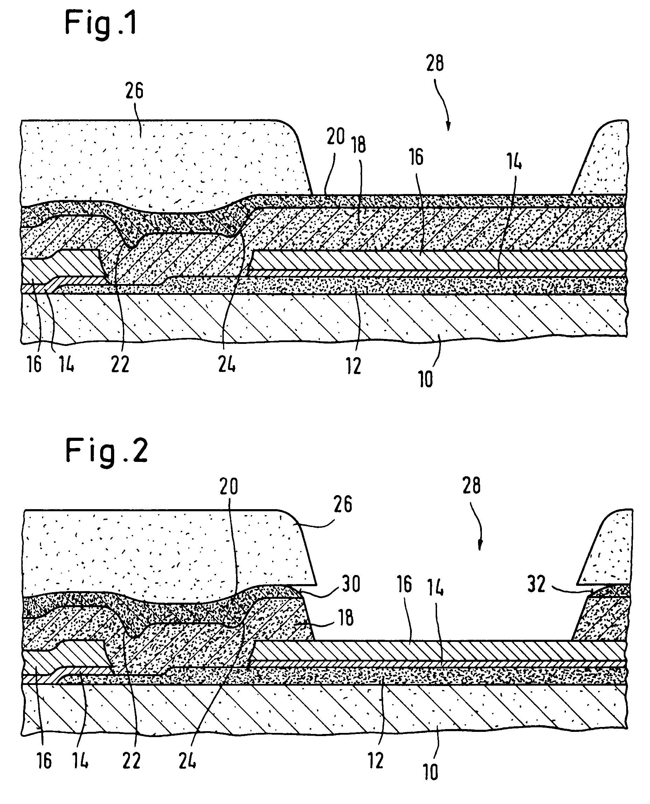

In Fig. 1 a semiconductor substrate 10 can be seen on which by using conventional method steps firstly a field oxide layer 12 and then a metallization layer have been formed, comprising in the example illustrated a thin TiW layer 14 and an aluminium layer 16. On the first metallization layer 14, 16 a first silicon dioxide layer 18 is formed as insulating layer. On this first silicon dioxide layer, using a spinning method, a further silicon dioxide layer 20 is formed which as can be seen in the drawings has a certain planarizing effect, i.e. causes steps present for example at the points 22 and 24 at the surface of the first silicon dioxide layer 18 to become flatter. In the literature this further silicon dioxide layer is referred to as "SOG layer" (abbreviation for spin-on-glass layer).

For reasons which will become apparent later, the second silicon dioxide layer 20 is subjected to a plasma oxidation which has a hardening effect on said layer.

Using known method steps, a photoresist mask 26 is then formed on the second silicon dioxide layer 20 and leaves free in a window region 28 an area of the layers lying therebelow at which a contact connection to the metallization layer 14, 16 is to be established.

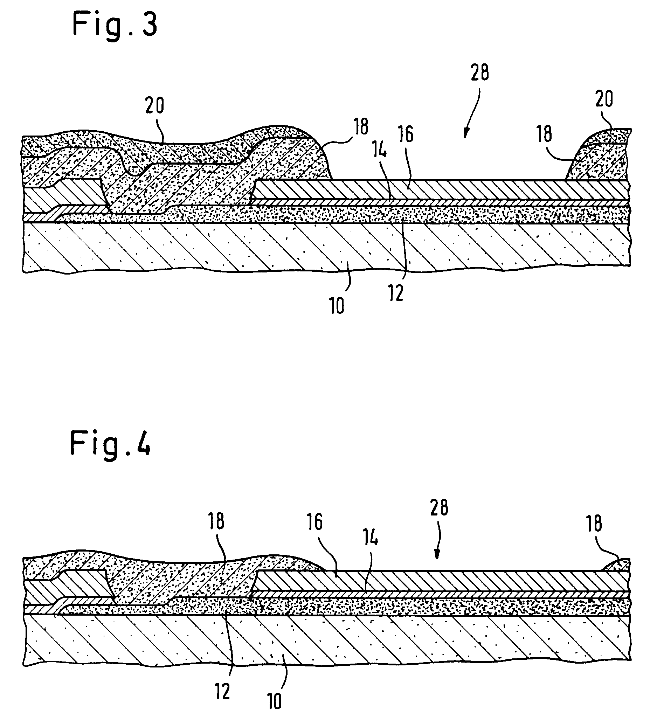

Through said contact window region 28 by means of an etching solution the two silicon dioxide layers 18 and 20 are removed. Because of the hardening process of the silicon dioxide layer 20 described above said layer has a greater etching rate than the silicon dioxide layer 18. As a result, the etching away of the silicon dioxide layer 20 in the lateral direction leads to a flattening at the edges at the borders of the contact window region 28 as can be seen at 30 and 32 in Fig. 2. After removal of the photoresist mask 26 the structure apparent in Fig. 3 results. It is clearly apparent therefrom that there is no longer a sharp-edged transition between the second silicon dioxide layer 20 and the contact window region 28.

In the next method step the second silicon dioxide layer 20 is completely removed, this removal being achieved by sputter etching. Since sputter etching is a purely physical isotropically acting process, there is no difference as regards the etching rate with respect to the silicon dioxide layer 20 and the silicon dioxide layer 18. The result is that at the areas at which the silicon dioxide layer 20 has already been etched away the silicon dioxide layer 18 is removed with the same etching rate. This is continued until the silicon dioxide layer 20 has completely disappeared. The result is then the structure of Fig. 4 in which it can be seen that the surface profile of the previously present silicon dioxide layer 20 has been completely transferred to the silicon dioxide layer 18 lying therebelow by the sputter etching. Consequently, all the sharp-edged steps at the borders of the contact window region 28 have also disappeared; all that remains are transitions with shallow rise angles which can readily be covered by a second metallization layer to be subsequently applied on the structure of Fig. 4 without encountering any coverage problems at the edges of the contact window region 28.

It has thus been shown that when using the method described the coverage problems at the edges of contact windows no longer occur. The method does not require any additional method steps which do not in any case have to be employed in the fabrication of integrated circuits. It is merely necessary to lengthen the sputtering etching somewhat in order to completely remove the second silicon dioxide layer 20. However, this lengthening of the method step is negligible compared with the substantially improved yield in the fabrication of integrated circuits which can be achieved when using the method described.

## Claims

1. A method of improving the step coverage at contact windows for establishing contact connections between a lower first metallization layer and an upper second metallization layer in the fabrication of integrated semiconductor circuits, characterised by the following steps:
forming a silicon dioxide layer on one of the metallization layer;
applying a further layer of silicon dioxide on the silicon dioxide layer;
hardening the further silicon dioxide layer;
forming a photoresist mask on the further silicon dioxide layer which at predetermined areas leaves windows at which a contact connection to the metallization layer is to be established;
removing the silicon dioxide layers in the exposed areas of the photoresist mask, until the lower metallization layer is exposed; and
removing the remainder of the further silicon dioxide layer.

2. A method according to claim 1, characterised in that the step of applying a further layer comprises carrying out a spinning operation and thereby applying the further layer.

3. A method according to claim 1 or claim 2, characterised in that the hardening of the further silicon dioxide is produced by subjecting the further silicon dioxide layer to plasma oxidation.

4. A method according to any preceding claim, characterised in that removing the silicon dioxide in the exposed areas comprise using an etching solution.

5. A method according to any preceding claim, characterised in that removing the remainder of further silicon dioxide comprises sputter etching.

6. A method according to any preceding claim, characterised in that the further silicon dioxide layer is applied with a thickness of about 100 to 300 nm.

7. A contact between first and second metallisation layers made to a method according to any preceding claim.
